(19) Europäisches Patentamt
European Patent Office
Office européen des brevets

(11) **EP 2 560 280 A2**

(12) **EUROPEAN PATENT APPLICATION**
published in accordance with Art. 153(4) EPC

(43) Date of publication:
**20.02.2013   Bulletin 2013/08**

(51) Int Cl.:
***H03F 3/217*** *(2006.01)*      ***H03F 3/38*** *(2006.01)*

(21) Application number: **11769019.8**

(86) International application number:
**PCT/KR2011/002483**

(22) Date of filing: **08.04.2011**

(87) International publication number:
**WO 2011/129553 (20.10.2011 Gazette 2011/42)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.04.2010   KR 20100033953**

(71) Applicants:
• **Avinc Co., Ltd.**
**Anyang-si, Gyeonggi-do 430-817 (KR)**

• **Song, Byoung-il**
**Gunpo-si, Gyeonggi-do 435-765 (KR)**

(72) Inventor: **SONG, Byoung-Il**
**Gunpo-si**
**Gyeonggi-do 435-765 (KR)**

(74) Representative: **Zacco Denmark A/S**
**Hans Bekkevolds Allé 7**
**2900 Hellerup (DK)**

(54) **PUBLIC ADDRESS AMPLIFIER WHICH IS LIGHTWEIGHT DUE TO THE SUPPLY OF CLASS-D SAMPLING FREQUENCY TO OPT**

(57)    Disclosed is a lightweight digital amplifier. The digital amplifier includes a signal input unit which receives an analog signal to be amplified; a signal modulation unit which modulates the analog signal received in the signal input unit into a digital signal and amplifies the modulated signal; a signal amplification unit which amplifies the digital signal of low power output from the signal modulation unit into a plurality of high power digital signals having different amplitudes; a plurality of filters which restore the respective high power digital signals amplified by the signal amplification unit into a plurality of amplified analog signals; an output selection unit which selects one filter among the plurality of filters and outputs the amplified analog signal of the selected filter; and a speaker terminal through which the amplified analog signal is transmitted from the output selection unit to an external speaker, thereby achieving reduction in volume and weight.

FIG. 3

EP 2 560 280 A2

**Description**

[Technical Field]

The present invention relates to an amplifier, and more particularly, to a public address broadcasting amplifier having decreased weight by supplying a class-D sampling frequency to an OPT.

[Background Art]

In general, a digital amplifier modulates a pulse width of a signal having small amplitude into a PWM signal, amplifies the amplitude of the PWM signal to a large amplitude, and extracts an audio signal from the amplified PWM signal through a low pass filter.

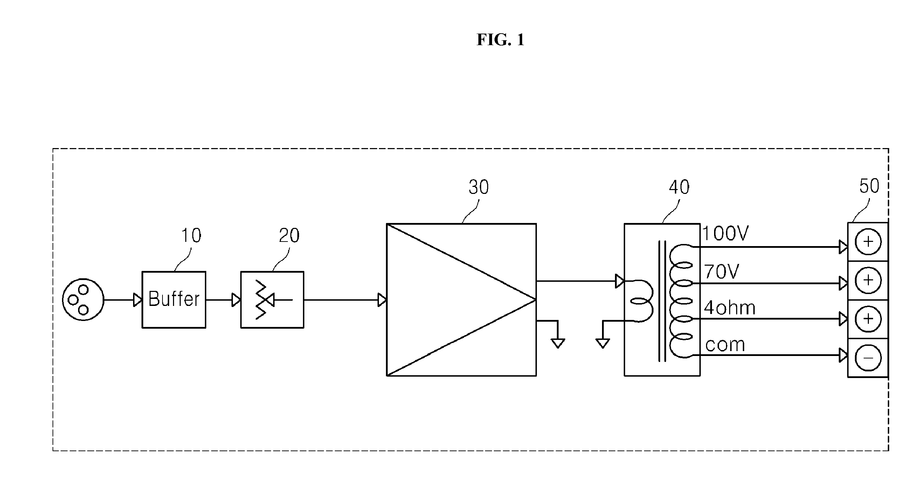

Fig. 1 is a block diagram of a conventional AB amplifier. Referring to Fig. 1, the amplifier includes a buffer 1, a signal adjustment unit 20, a class AB amplifying unit 30, a signal amplification unit 40, and a terminal 50.

A signal input through the buffer 1 is controlled in volume by the signal adjustment unit 20, amplified by the class AB amplifying unit 30 in accordance with a turn number of coils, and then transmitted to an external speaker through the terminal 50. In this case, the size and weight of the signal amplification unit 40 amplifying a frequency of a voice band are so large that the size and weight of the whole amplifier increases. Further, loss occurring in the signal amplification unit 40 is about 13%, thereby causing deterioration in efficiency of the whole system.

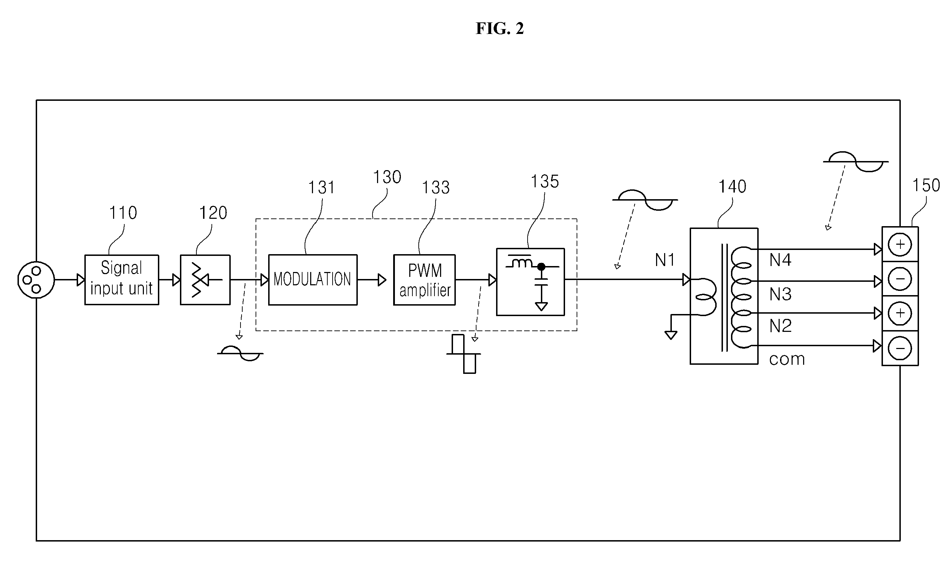

Fig. 2 is a block diagram of a conventional digital amplifier. Referring to Fig. 2, the digital amplifier includes a signal input unit 110, a signal adjustment unit 120, a class d amplifying unit 130, a modulator 131, a PWM amplifier 133, a filter unit 135, a signal amplification unit 140, and a terminal 150.

A signal input through the signal input unit 110 is controlled in volume by the signal adjustment unit 120, modulated into a PWM signal by the modulator 131 in the class d amplifying unit 130, amplified by the PWM amplifier 133, and filtered by the filter unit 135. Then, the filtered signal is amplified by the signal amplification unit 140 and transmitted to an external speaker through the terminal 150.

In this case, the signal amplification unit 140 amplifies a signal of an audio frequency band of 20-20,000 Hz, and thus increases in size and weight.

The foregoing related arts have been held by the present inventor to conceive the present invention or obtained by the present inventor while conceiving the present invention, but they are not necessarily publicly known prior to filing of the present invention.

[Disclosure]

[Technical Problem]

An aspect of the present invention is to provide digital amplifiers configured to amplify a high frequency signal to reduce volume and weight thereof.

The above and other aspect and objects of the present invention will become apparent through the following descriptions.

[Technical Solution]

One aspect of the present invention provides a digital amplifier including: a signal input unit which receives an analog signal to be amplified; a signal modulation unit which modulates the analog signal received in the signal input unit into a digital signal and amplifies the modulated signal; a signal amplification unit which amplifies the digital signal of low power output from the signal modulation unit into a plurality of high power digital signals having different amplitudes; a plurality of filters which restore the respective high power digital signals amplified by the signal amplification unit into a plurality of amplified analog signals; an output selection unit which selects one filter among the plurality of filters and outputs the amplified analog signal of the selected filter; and a speaker terminal through which the amplified analog signal is transmitted from the output selection unit to an external speaker.

Another aspect of the present invention provides a digital amplifier including: a signal input unit which receives an analog signal to be amplified; a signal modulation unit which modulates the analog signal received in the signal input unit into a digital signal and amplifies the modulated signal; a signal amplification unit which amplifies the digital signal of low power output from the signal modulation unit into a plurality of high power digital signals having different amplitudes; an output selection unit which selects and outputs one high power digital signal from among the plurality of high power digital signals amplified in the signal amplification unit; a plurality of filters which restore the digital signal selected and output by the output selection unit into an amplified analog signal; and a speaker terminal through which the amplified analog signal is transmitted from the filter to an external speaker.

The digital amplifier may further include a first abnormality detector which connects with the signal modulation unit and detects whether the modulated digital signal is abnormal; and a second abnormality detector which connects with the speaker terminal and detects whether the amplified analog signal is abnormal.

The digital amplifier may further include a switching controller which controls the output selection unit to select and output one high power digital signal from among the plurality of high power digital signals amplified by the signal amplification unit.

The digital amplifier may further include a user manipulator through which a user inputs selection information to the switching controller.

Here, the low power digital signal may have a frequency of 300 KHz to 400 KHz, and the amplified analog signal may have a frequency of 20 Hz to 20,000 Hz.

The above and other aspect, features and advantages of the present invention will become apparent from the following detailed description and claims in conjunction with the accompanying drawings.

[Advantageous Effects]

The lightweight digital amplifier according to the present invention amplifies a high frequency signal, thereby enabling decrease in volume and weight.

[Description of Drawings]

Fig. 1 is a block diagram of a conventional class AB amplifier.
Fig. 2 is a block diagram of a conventional digital amplifier.
Fig. 3 is a block diagram of a digital amplifier according to one embodiment of the present invention.
Fig. 4 is a block diagram of a digital amplifier according to another embodiment of the present invention.

[Best Mode]

In accordance with one aspect of the present invention, a digital amplifier includes: a signal input unit which receives an analog signal to be amplified; a signal modulation unit which modulates the analog signal received in the signal input unit into a digital signal and amplifies the modulated signal; a signal amplification unit which amplifies the digital signal of low power output from the signal modulation unit into a plurality of high power digital signals having different amplitudes; a plurality of filters which restore the respective high power digital signals amplified by the signal amplification unit into a plurality of amplified analog signals; an output selection unit which selects one filter among the plurality of filters and outputs the amplified analog signal of the selected filter; and a speaker terminal through which the amplified analog signal is transmitted from the output selection unit to an external speaker.

In accordance with another aspect of the present invention, a digital amplifier includes: a signal input unit which receives an analog signal to be amplified; a signal modulation unit which modulates the analog signal received in the signal input unit into a digital signal and amplifies the modulated signal; a signal amplification unit which amplifies the digital signal of low power output from the signal modulation unit into a plurality of high power digital signals having different amplitudes; an output selection unit which selects and outputs one high power digital signal from among the plurality of high power digital signals amplified in the signal amplification unit; a plurality of filters which restore the digital signal selected and output by the output selection unit into an amplified analog signal; and a speaker terminal through which the amplified analog signal is transmitted from the filter to an external speaker.

The digital amplifier may further include a first abnormality detector which connects with the signal modulation unit and detects whether the modulated digital signal is abnormal; and a second abnormality detector which connects with the speaker terminal and detects whether the amplified analog signal is abnormal.

The digital amplifier may further include a switching controller which controls the output selection unit to select and output one high power digital signal from among the plurality of high power digital signals amplified by the signal amplification unit.

The digital amplifier may further include a user manipulator through which a user inputs selection information to the switching controller.

Here, the low power digital signal may have a frequency of 300 KHz to 400 KHz, and the amplified analog signal may have a frequency of 20 Hz to 20,000 Hz.

[Mode for Invention]

The present invention may be realized in various ways and may provide various embodiments. Thus, the present invention will be described with reference to particular exemplary embodiments. However, it should be understood that the present invention is not limited to the following embodiments, and that various modifications, substitutions, and equivalent embodiments can be made without departing from the spirit and scope of the present invention.

Although the terms first, second, etc. may be used herein to describe various elements or components, these elements or components should not be limited by these terms.

The terms used herein are for the purpose of describing particular exemplary embodiments and are not to be construed in any way as limiting the present invention. As used herein, the singular forms "a," "an," and "the" may be intended to include the plural forms as well unless the context clearly indicates otherwise. It should be understood that the terms "comprises," "comprising," "includes," "including," and "having" are inclusive and thus specify the presence of stated features, integers, operations, elements, components and/or combinations thereof, but do not preclude the presence or addition of one or more other features, integers, operations, elements, components and/or combinations thereof.

In addition, in description of the present invention with reference to the accompanying drawings, the same elements will be indicated by the same reference numerals and repeated descriptions thereof will be omitted. Descriptions of details apparent to those skilled in the art will be omitted.

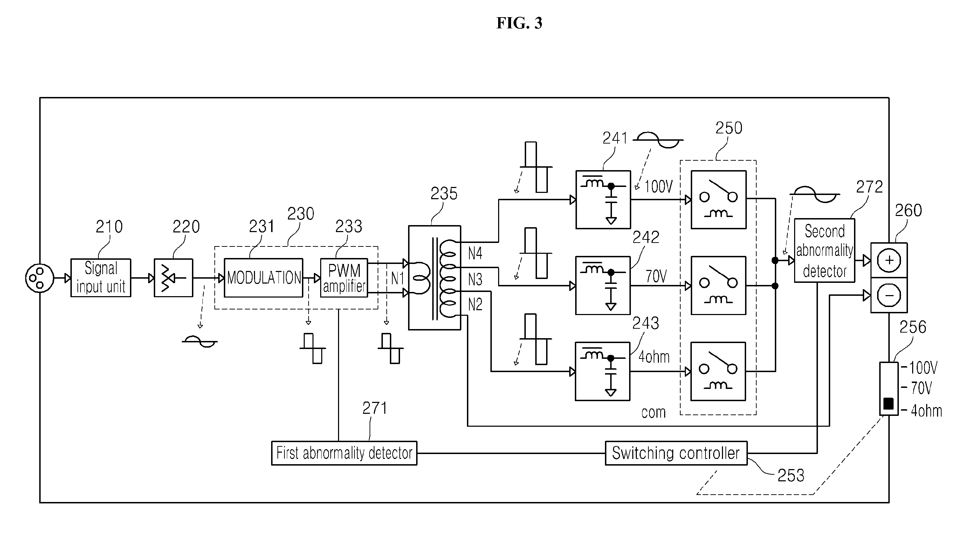

Fig. 3 is a block diagram of a digital amplifier according to one embodiment of the present invention. Referring to Fig. 3, the digital amplifier includes a signal input unit 210, a signal adjustment unit 220, a signal modulation unit 230, a modulator 231, a PWM amplifier 233, a signal amplification unit 235, a first filter 241, a second filter 242, a third filter 243, an output selection unit 250, a switching controller 253, a user manipulator 256, a speaker terminal 260, a first abnormality detector 271, and a second abnormality detector 272.

The present embodiment provides a digital amplifier which is configured to amplify a high frequency signal and thus has small volume and weight. According to this embodiment, a signal to be amplified by the signal amplification unit 235 (output trans.: OPT) is a digital signal having a high sampling frequency, which allows the signal amplification unit 235 to be further decreased in size and weight than a conventional amplifying unit.

The signal input unit 210 receives an analog signal to be amplified. The received signal may be an audio signal for public address broadcasting.

The signal adjustment unit 220 serves to adjust the amplitude of an analog signal, like a volume adjuster. For example, the amplitude of the signal may be adjusted to change electric current through adjustment of resistance.

The signal modulation unit 230 modulates the analog signal received in the signal input unit 210 into a digital signal, and amplifies the modulated digital signal. The signal modulation unit 230 may include a modulator 231 which samples and modulates the received analog signal into a digital signal (having a PWM waveform), and a PWM amplifier 233 which amplifies the modulated digital signal to a predetermined amplitude. The signal modulated by the signal modulation unit 230 may have a frequency of 300 KHz to 400 KHz, and the signal amplified by the PWM amplifier 233 may have a frequency of 300 KHz to 400 KHz.

The signal amplification unit 235 amplifies the digital signal of low power output from the signal modulation unit 230 into a plurality of high power digital signals having different amplitudes. The signal amplification unit 235 may include a first coil to which an input signal is input, and a second coil from which an output signal is output, in which the first coil and the second coil are adjacent to each other. In this case, the first coil may have a turn number of 'N1', and the second coil may have a turn number of 'N2+N3+N4'. Amplifying rate of the signal may be determined depending on the turn number of the second coil, and the signal amplification unit 235 may output the plurality of high power digital signals having different amplitudes since the turn numbers of respective coils are distinguished. The frequency of the output signal may range from 300 KHz to 400 KHz.

The first filter 241, the second filter 242 and the third filter 243 serve to restore the respective high power digital signals amplified by the signal amplification unit 235 into a plurality of amplified analog signals. The number of filters 241, 242, 243 may correspond to the number of high power digital signals to be output from the signal amplification unit 235.

The filters 241, 242, 243 may include one of a low pass filter (LPF), a band pass filter (BPF), a high pass filter (HPF) and a band stop filter (BSF), a band reject filter (BRF), and a notch filter. Here, the amplified analog signal may have a frequency ranging from 20 Hz to 20,000 Hz.

According to the present embodiment, the signal amplification unit 235 amplifies a high frequency digital signal, thereby enabling reduction in size and weight thereof. For example, a conventional E-I core or troidal core used as a signal amplifier for amplifying a voice band frequency of 20 Hz to 20,000 Hz has a diameter of about 150 mm, a height of about 50 mm, and a weight of about 2 kg in the case of a 400W level. On the contrary, the signal amplification unit 235 according to this embodiment has a diameter of about 50 mm, a height of about 25 mm, and a weight of about 300 g. Thus, the volume and weight of the signal amplification unit according to this embodiment may be effectively further decreased about twenty times that of the conventional signal amplification unit.

That is, according to this embodiment, based on Faraday's law, the size and weight of the signal amplification unit 235 decreases with increasing frequency of a signal to be amplified. That is, WaWc of a transformer is determined by the following Expression 1:

$$WaAc = (kP_o * 10e8)/(B*f),$$

(waac= window area in x core area in)
where, k is 0.00633, po is an output power, B is a flux density in gauss, and f is a frequency with regard to toroids. That is, the frequency is inversely proportional to the size. In the related art, it is necessary to reproduce a low band frequency of a voice band width 20 Hz-20 KHz, and thus f is 20Hz. According to this embodiment, since a sampling frequency of 300 KHz is provided as f, it is possible to relatively reduce the size by the foregoing Expression 1. The output selection unit 250 selects one filter from among the plurality of filters 241, 242, 243 and outputs the amplified analog signal received through the selected filter.

The switching controller 253 controls the output selection unit 250 to select and output one high power digital signal from among the plurality of high power digital signals amplified in the signal amplification unit 235. That is, as shown in Fig. 3, the switching controller 253 may control a switch to be on/off, thereby allowing the output selection unit 250 to select a signal to be output.

The user manipulator 256 allows a user to input user selection to the switching controller 253. The user manipulator 256 may be realized by a user interface such as a button. The user manipulator 256 may be connected to the switching controller 253 via wire or wirelessly. For example, the user manipulator 256 may be a remote controller, and information transmitted from the user manipulator 256 may be received by the switching controller 253 capable of receiving the corresponding information, whereby the switching controller 253 can control the output selection unit 250 in response to the received information.

The speaker terminal 260 is a terminal for connecting with an external speaker and transmits the amplified analog signal output from the output selection unit 250 to the external speaker.

The first abnormality detector 271 and the second abnormality detector 272 serve to determine whether a signal is abnormal. The first abnormality detector 271 detects voltage applied to a resistor Ron (resistance at switching on) and determines abnormality if the detected voltage is greater than or equal to a certain voltage. The second abnormality detector 272 applies shunt resistance to a (+) terminal of the speaker in series, and determines abnormality if more than a certain level of electric current flows.

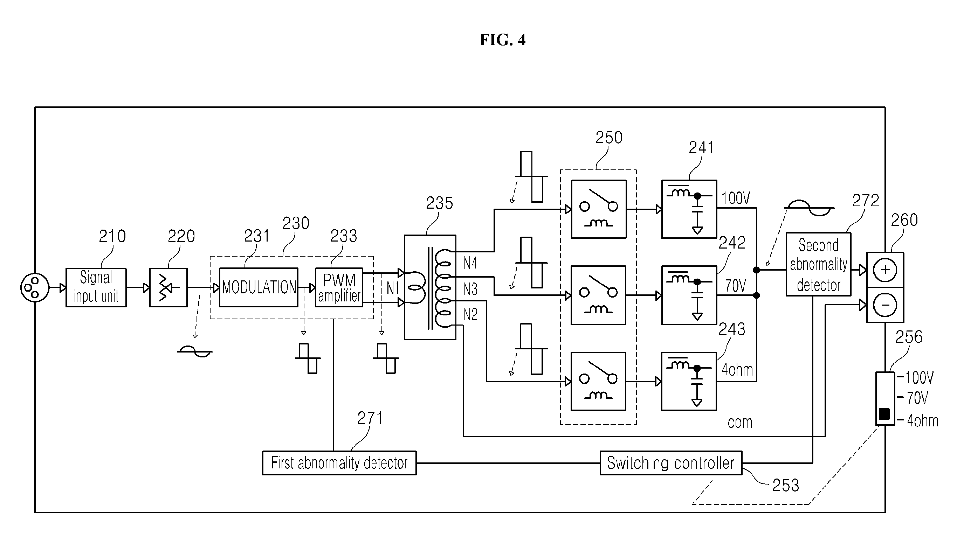

Fig. 4 is a block diagram of a digital amplifier according to another embodiment of the present invention. Referring to Fig. 4, the digital amplifier according to this embodiment includes a signal input unit 210, a signal adjustment unit 220, a signal modulation unit 230, a modulator 231, a PWM amplifier 233, a signal amplification unit 235, a first filter 241, a second filter 242, a third filter 243, an output selection unit 250, a switching controller 253, a user manipulator 256, a speaker terminal 260, a first abnormality detector 271, and a second abnormality detector 272. Below, different components from the above embodiment will be described.

On the contrary to the foregoing embodiment, the output selection unit 250 according to this embodiment is connected to the signal amplification unit 235, and the filters 241, 242, 243 serve to filter a signal selected by the output selection unit 250.

The output selection unit 250 selects and outputs one high power digital signal from among a plurality of high power digital signals amplified by the signal amplification unit 235.

The first filter 241, the second filter 242, and the third filter 243 serve to restore the high power digital signal selected and output by the output selection unit 250 into the amplified analog signal.

The speaker terminal 260 transmits the amplified analog signal from the filters 241, 242, 243 to the external speaker.

Detailed descriptions of interface standardization technology including signal amplification, filtering, communication, input/output (I/O) interface, and the like of the digital amplifier according to other embodiments of the present invention are obvious to those skilled in the art and thus omitted herein.

Further, it will be appreciated by those skilled in the art that various modification and alterations can be made without departing from the scope and spirit of the present invention defined only by the appended claims and their equivalents.

[Industrial Applicability]

The present invention may be applied to modulation or amplification of audio signals.

**Claims**

1. A digital amplifier comprising:

   a signal input unit which receives an analog signal to be amplified;
   a signal modulation unit which modulates the analog signal received in the signal input unit into a digital signal and amplifies the modulated signal;
   a signal amplification unit which amplifies the digital signal of low power output from the signal modulation unit into a plurality of high power digital signals having different amplitudes;
   a plurality of filters which restore the respective high power digital signals amplified by the signal amplification unit into a plurality of amplified analog signals;
   an output selection unit which selects one filter among the plurality of filters and outputs the amplified analog signal of the selected filter; and
   a speaker terminal through which the amplified analog signal is transmitted from the output selection unit to an external speaker.

2. A digital amplifier comprising:

   a signal input unit which receives an analog signal to be amplified;
   a signal modulation unit which modulates the analog signal received in the signal input unit into a digital signal and amplifies the modulated signal;
   a signal amplification unit which amplifies the digital signal of low power output from the signal modulation unit into a plurality of high power digital signals having different amplitudes;
   an output selection unit which selects and outputs one high power digital signal from among the plurality of high power digital signals amplified in the signal amplification unit;
   a plurality of filters which restore the digital signal selected and output by the output selection unit into an amplified analog signal; and
   a speaker terminal through which the amplified analog signal is transmitted from the filter to an external speaker.

3. The digital amplifier according to claim 1 or 2, further comprising
   a first abnormality detector which connects with the signal modulation unit and detects whether the modulated digital signal is abnormal; and
   a second abnormality detector which connects with the speaker terminal and detects whether the amplified analog signal is abnormal.

4. The digital amplifier according to claim 1 or 2, further comprising:

   a switching controller which controls the output selection unit to select and output one high power digital signal from among the plurality of high power digital signals amplified by the signal amplification unit.

5. The digital amplifier according to claim 1 or 2, further comprising:

   a user manipulator through which a user inputs selection information to the switching controller.

6. The digital amplifier according to claim 1 or 2, wherein the low power digital signal has a frequency of 300KHz to 400KHz.

7. The digital amplifier according to claim 1 or 2, wherein the amplified analog signal has a frequency of 20Hz to 20,000Hz.

**FIG. 1**

FIG. 2

EP 2 560 280 A2

**FIG. 3**

210 Signal input unit

220

230 231 MODULATION

233 PWM amplifier

235

N1 N2 N3 N4

241 → 100V

242 70V

243 4ohm

250 com

253 Switching controller

271 First abnormality detector

272 Second abnormality detector

260 + −

256 100V 70V 4ohm

**FIG. 4**